# EUROPÄISCHE PATENTSCHRIFT

(11) **EP 0 857 406 B1**
(45) Veröffentlichungstag und Bekanntmachung des Hinweises auf die Patenterteilung: **24.03.1999**
(21) Anmeldenummer: 96934778.0
(22) Anmeldetag: 22.10.1996
(51) Int. Cl.: H05K 9/00

(54) **HF-DICHTER SCHALTSCHRANK**
HIGH-FREQUENCY-SHIELDED SWITCHGEAR CABINET
ARMOIRE DE DISTRIBUTION ETANCHE AUX HAUTES FREQUENCES

(30) Priorität: 28.10.1995 DE 19540332
(43) Veröffentlichungstag der Anmeldung: 12.08.1998
(73) Patentinhaber: Rittal-Werk Rudolf Loh GmbH & Co. KG, 35745 Herborn (DE)
(72) Erfinder: ELM, Oskar, D-35716 Dietzhölztal (DE); NICOLAI, Walter, D-35418 Buseck (DE); SCHNAUBELT, Jürgen, D-35716 Dietzhölztal 1 (DE); SCHÜLER, Matthias, D-35716 Dietzhölztal 2 (DE)
(74) Vertreter: Fleck, Hermann-Josef, Dr.-Ing.
(86) Internationale Anmeldenummer: EP9604577
(87) Internationale Veröffentlichungsnummer: WO9716950

(56) Entgegenhaltungen:
- EP-A- 0 428 335
- DE-A- 4 207 308
- US-A- 5 214 242
- CHEMICAL ABSTRACTS, vol. 55, no. 6, 8.Januar 1962 Columbus, Ohio, US; abstract no. 111 217599, BERGSTROEM: "Aluzink with good coating ductility for severe forming applications" XP002025052 & EDWARDS, "Zinc Coated Steel sheet, Ed. Proc., Int. Conf., 2nd (1989), Meeting Date 1988, SC5/1-SC5/8 "

## Beschreibung

Die Erfindung betrifft einen HF-dichten Schaltschrank mit aus Wandelementen zusammensetzbarem oder zusammengesetztem Schrankkorpus, der mindestens eine mittels Schranktüre verschließbare Öffnung aufweist und bei dem am Schrankkorpus und zwischen Schrankkorpus und Schranktüre gebildete Spalte mittels elektrisch und magnetisch leitenden Dichtungsstreifen HF-dicht verschlossen oder verschließbar sind.

Die Herstellung eines HF-dichten Schaltschrankes mit ausreichend großer Lebensdauer ist sehr aufwendig und daher auch entsprechend teuer. Dabei hängt es noch wesentlich davon ab, ob der Schaltschrank ein Rahmengestell aufweist, an dem die Wandelemente und die Schranktüre angebracht sind, oder ob die Wandelemente selbst zu einem einstückigen Schrankkorpus verbunden, z.B. verschweißt sind.

Es ist bekannt, Schaltschränke aus Edelstahl herzustellen, wobei im Bereich der Spalte Kontaktstreifen angebracht werden, die die HF-Dichtung übernehmen.

Es ist auch bekannt, um eine HF-Abdichtung zu erreichen, in dem Schrankkorpus einen getrennten, geschlossenen Einsatz einzubringen, wie die DE 36 11 693 C1 zeigt. Der zusätzliche Einsatz verteuert den Schaltschrank beachtlich.

Aus der DE 91 00 798 U1 ist ein Verfahren zum Herstellen eines Blechgehäuses aus einem Gehäusekorpus mit mindestens einer Öffnung bekannt, die mittels eines Verschlußteiles, wie Tür, Wandelement, Bodenplatte, Deckplatte, Flanschplatte oder dgl. verschließbar ist, wobei das Verschlußteil um die Öffnung des Gehäusekorpus elektrisch und magnetisch leitend mit diesem verbindbar ist.

Der Gehäusekorpus wird nach seiner Herstellung aus Blech um die Öffnung mit einer Kontaktfläche versehen. Diese Kontaktfläche wird mit einem Abdeckband abgedeckt, bevor er gereinigt und anschließend lackiert wird. Zum Schluß wird dann das Abdeckband entfernt. Die Kontaktfläche wird aus gut leitfähigem und korrosionsbeständigem Material aufgeschmolzen oder aufgeschweißt, wozu vorzugsweise die Lasertechnik verwendet wird. Dieses Verfahren ist nicht nur aufwendig, es erfordert auch einen erheblichen Vorrichtungsaufwand, um durchgeführt zu werden.

Wie die DE 42 07 308 A1 zeigt, ist dieses bekannte Verfahren dahingehend verbessert worden, daß der Gehäusekorpus vor dem Anbringen der Kontaktflächen eingefettet und um die Öffnung des Gehäusekorpus die Kontaktfläche im Flammspritzverfahren auf dem eingefetteten Gehäusekorpus aufgebracht wird. Die Kontaktfläche wird danach mit dem Abdeckband abgedeckt, der Gehäusekorpus gereinigt und anschließend lackiert. Zum Schluß wird das Abdeckband entfernt. Auf diese Weise wird der Vorrichtungsaufwand reduziert und die Herstellung des Schaltschrankes vereinfacht.

Die Korrosionsbeständigkeit im Bereich der Kontaktflächen ist jedoch nicht ausreichend, was zu einer Verkürzung der Lebensdauer und einem Nachlassen der HF-Abschirmung führt.

Es ist Aufgabe der Erfindung, einen HF-dichten Schaltschrank der eingangs erwähnten Art zu schaffen, der unter Beibehaltung eines geringen Vorrichtungsaufwandes eine einfache Herstellung zuläßt und dennoch zu einer Erhöhung der Lebensdauer bei verminderter Korrosionsgefahr führt.

Diese Aufgabe wird nach der Erfindung dadurch gelöst, daß die Wandelemente und die Schranktüre aus Aluzink-beschichtetem Blech gefertigt und zumindest in den abzudichtenden Spalten zugekehrten Bereichen ohne zusätzlichen Oberflächenschutzbelag versehen sind, und daß die Dichtungsstreifen direkt mit der unbehandelten Oberfläche der Wandelemente und/oder Schranktüre verbunden sind.

Die Verwendung von Aluzink-beschichtetem Blech hat den Vorteil, daß auf teueren Edelstahl und korrosionsanfälliges chromatisiertes Stahlblech verzichtet werden kann. Die gesamten Oberflächen des Schrankkorpus können ohne Oberflächenschutzbelag verwendet werden. Ist eine optische Anpassung an andere Schaltschränke erforderlich, dann kann die Aufbringung eines Oberflächenschutzbelages auf die Außenseiten beschränkt bleiben. Die elektrisch und magnetisch leitenden Dichtungsstreifen zur HF-Abdichtung der Spalte können direkt mit der unbehandelten Innenseite des Schrankkorpus verbunden werden. Die Verbesserung im Korrosionsschutz beruht auf der Ausbildung von festen und festhaftenden Deckschichten auf dem verwendeten Ausgangsmaterial und auf der kathodischen Schutzwirkung des Zinkanteils gegenüber Stahl. Die Abtragungswerte gegenüber blankem Stahlblech reduzieren sich auf Bruchteile, was sich in einer mehrfachen Erhöhung der Lebensdauer des neuen Schaltschrankes gerade im Bereich der die HF-Abdichtung bewirkenden Kontaktstellen vorteilhaft auswirkt.

Eine Ausgestaltung des neuen Schaltschrankes ist dadurch gekennzeichnet, daß er ein aus Aluzink-Blech gefertigtes Rahmengestell ohne zusätzlichen Oberflächenschutzbelag aufweist, an dem die mittels Dichtungsstreifen abgedichteten Wandelemente und die Schranktüre angebracht sind. Dabei können die Dichtungsstreifen fest am Rahmengestell oder fest an den Wandelementen und der Schranktüre angebracht sein. Dabei wird schon bei der Herstellung des Rahmengestelles eine beachtliche Einsparung erzielt.

Ist aus optischen Gründen eine Anpassung erforderlich, dann kann sich diese auf die Außenseite der Wandelemente und der Schranktüre beschränken und eine Pulverbeschichtung oder eine Lackierung umfassen.

Sind Zusatzteile, wie Flanschplatte oder dgl., am Schrankkorpus anzubringen, dann ist die Ausgestaltung vorzugsweise so, daß Offnungen in den Wandelementen des Schrankkorpus mittels aus Aluzink-Blech gefertigten Flanschplatten oder dgl. verschließbar sind, die in bekannter Weise über Dichtungselemente in Flanschplattenöffungen der Wandelemente einsetzbar sind, wobei die Flanschplatten oder dgl. auf den den Innenseiten des Schrankkorpus zugekehrten Seiten ohne Oberflächenschutzbelag versehen sind und die Dichtungselemente tragen und daß die Flanschplattenöffnungen zumindest in den zugekehrten Anlageflächen ohne Oberflächenschutzbelag sind.

Die Erfindung wird anhand von in den Zeichnungen dargestellten Ausführungsbeispielen näher erläutert. Es zeigen:
- Fig. 1: einen Schaltschrank mit Rahmengestell bei geöffneter Schranktüre,

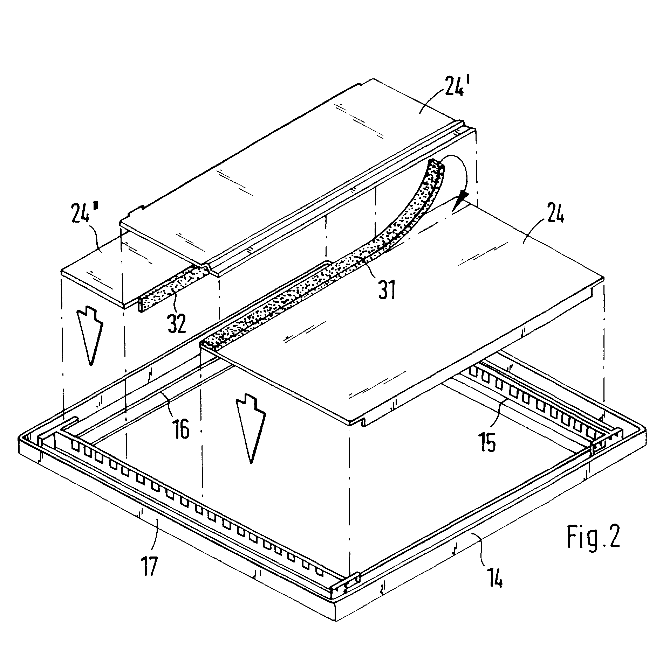

- Fig. 2: eine besondere Art des HF-dichten Verschlusses der Bodenseite des Schaltschrankes nach Fig. 1 und
- Fig. 3: einen als Wandgehäuse ausgebildeten Schaltschrank bei geöffneter Schranktüre.

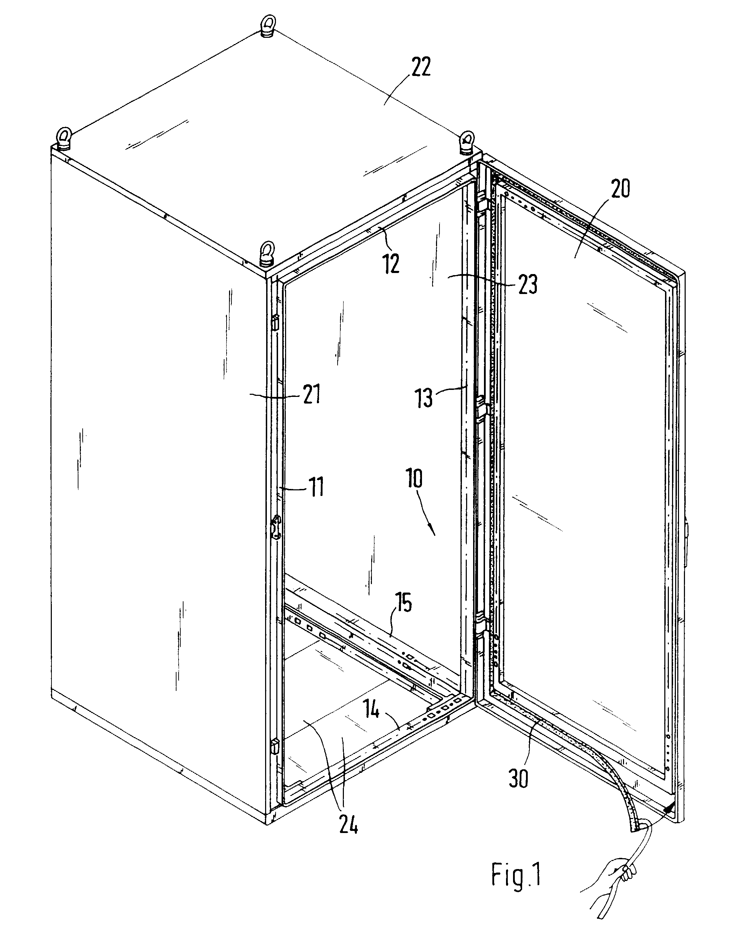

Der Schaltschrank nach Fig. 1 weist ein Rahmengestell 10 auf, von dem die in der Perspektive zu sehenden Rahmenschenkel mit 11,12, 13,14 und 15 bezeichnet sind. Alle Rahmenschenkel des Rahmengestelles 10 sind aus Aluzink-beschichtetem Stahlblech hergestellt und blank belassen, so daß die Wandelemente 21,22, 23 und 24 sowie die Schranktüre 20 mit dem Rahmengestell 10 auf einfache Weise elektrisch und magnetisch leitend in Verbindung gebracht werden können. Dabei sind die Wandelemente 21,22, 23 und 24 sowie die Schranktüre 20 ebenfalls aus Aluzink-beschichtetem Stahlblech hergestellt, das leicht zu verarbeiten ist und zumindest auf den dem Innenraum des Schrankkorpus zugekehrten Innenseiten blank ist. Die elektrisch und magnetisch leitenden Dichtungsstreifen 30 für die HF-Abdichtung der Übergangsspalte können dabei direkt am Rahmengestell 10 oder an den Wandelementen 21,22, 23 und 24 und der Schranktüre 20 befestigt werden. Die Dichtungsstreifen 30 sind dabei vorzugsweise selbstklebend ausgebildet. Als Verbindungselemente für die Wandelemente 21,22, 23 und 24 und die Schranktüre 20 werden vorzugsweise Kunststoffteile oder polymerbeschichtete Teile verwendet, um Korrosionen an diesn Stellen zu vermeiden.

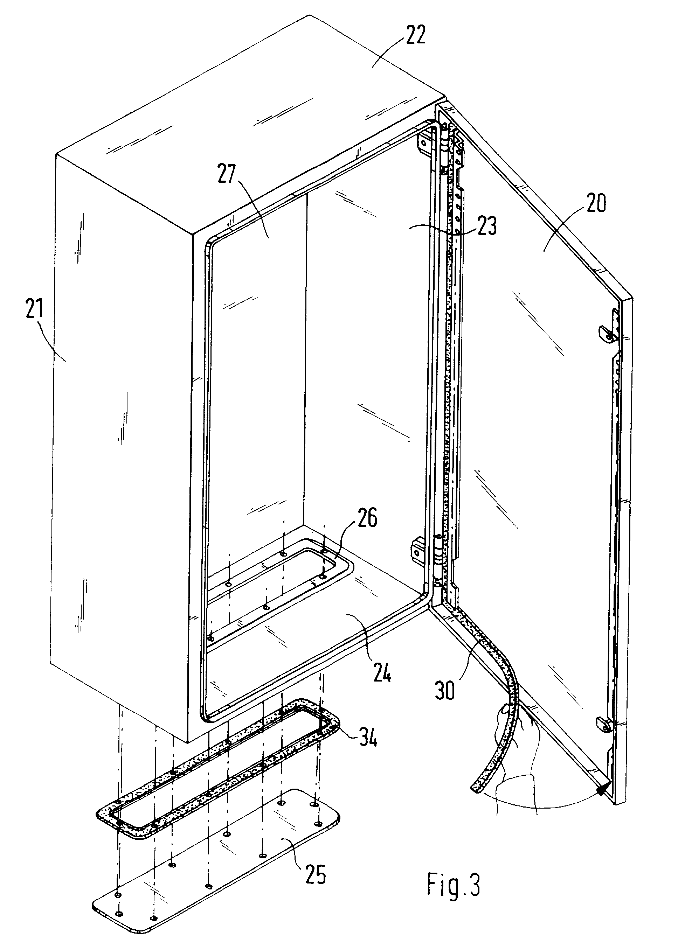

Wie Fig. 3 zeigt, kann die Bodenseite des Rahmengestelles 10 auch mittels geteilter Bodenbleche 24, 24' und 24" verschlossen werden. Dabei bilden die Rahmenschenkel 14,15, 16 und 17 einen unteren Rahmen, der einen umlaufenden Auflageabsatz für die Bodenbleche bildet, die dem Rahmen zugekehrt Dichtungsstreifen tragen. Die Bodenbleche 24, 24' und 24" bestehen aus Aluzink-beschichtetem Stahlblech und sind vorzugsweise beidseitig blank belassen. Dabei können sich die Bodenbleche 24, 24' und 24" teilweise überlappen und in den Überlappungsbereichen mit zusätzlichen Dichtungsstreifen 31 und 32 versehen sein, um eine vollständige HF-Abdichtung zu erreichen.

Der in Fig. 3 dargestellte Schaltschrank ist als Wandgehäuse ohne Rahmengestell ausgebildet, wobei die Wandelemente 21,22, 23 und 24 und die Rückwand 27 aus einer Zuschnitt gebogen und an den Stoßstellen zu einem einstückigen Schrankkorpus verschweißt sein können. Als Ausgangsmaterial wird wieder Aluzink-beschichtetes Stahlblech verwendet, das auf der Innenseite des Schaltschrankes blank bleibt. Die Außenseite des Schrankkorpus und der Schranktür 20 kann einen Oberflächenschutzbelag tragen, der als Pulverbeschichtung oder Lackierung ausgebildet sein kann. Das den Boden des Schaltschrankes bildende Wandelement 24 ist mit einer Flanschplattenöffnung 26 versehen, die in bekannter Weise von einem mit Befestigungsbohrungen versehenen, zurückgesetzten Rand umschlossen ist. Die aus Aluzink-beschichtetem Stahlblech bestehende Flanschplatte 25 wird unter Zwischenlage eines elektrisch und magnetisch leitenden Dichtungselementes 34 zum Verschluß der Flanschplattenöffnung 25 verwendet. Dabei ist die Flanschplatte 25 zumindest auf der der Flanschplattenöffnung 26 zugekehrten Seite blank belassen und mit dem Schrankkorpus verschraubt. Dabei werden vorzugsweise Kunststoff-Schrauben oder polymerbeschichtete Schrauben verwendet. Die HF-Abdichtung zwischen der Schranktüre 20 und dem Schrankkorpus übernimmt der auf der blanken Innenseite der Schranktüre 20 befestigte, vorzugsweise direkt aufgeklebte Dichtungsstreifen 30, der bei geschlossener Schranktüre 20 an dem umlaufenden Dichtungssteg des Schrankkorpus anliegt.

Der Schrankkorpus des Wandgehäuses kann auch aus den Wandelementen 21, 22, 23 und 24 sowie einer Rückwand 27 zusammengesetzt werden, wobei diese Teile an ihren Stoßstellen einfach miteinander verschweißt oder verlötet werden.

## Patentansprüche

1. HF-dichter Schaltschrank mit aus Wandelementen zusammensetzbarem oder zusammengesetztem Schrankkorpus, der mindestens eine mittels Schranktüre verschließbare Öffnung aufweist und bei dem am Schrankkorpus und zwischen Schrankkorpus und Schranktüre gebildete Spalte mittels elektrisch und magnetisch leitenden Dichtungsstreifen HF-dicht verschlossen oder verschließbar sind,
dadurch gekennzeichnet,
daß die Wandelemente (21,22, 23,24, 24',24") und die Schranktüre (20) aus Aluzink-beschichtetem Blech gefertigt und zumindest in den abzudichtenden Spalten zugekehrten Bereichen ohne zusätzlichen Oberflächenschutzbelag versehen sind, und
daß die Dichtungsstreifen (30,31, 32) direkt mit der unbehandelten Oberfläche der Wandelemente (21,22, 23,24, 24',24") und/oder Schranktüre (20) verbunden sind.

2. HF-dichter Schaltschrank nach Anspruch 1,
dadurch gekennzeichnet,
daß er ein aus Aluzink-Blech gefertigtes Rahmengestell (10) ohne zusätzlichen Oberflächenschutzbelag aufweist, an dem die mittels Dichtungsstreifen abgedichteten Wandelemente (21 bis 24) und die Schranktüre (20) angebracht sind (Fig. 1).

3. HF-dichter Schaltschrank nach Anspruch 1 oder 2,
dadurch gekennzeichnet,
daß die Außenseiten der Wandelemente (21 bis 24) und der Schranktüre (20) mit einer Pulverbeschichtung als Oberflächenschutzbelag versehen sind.

4. HF-dichter Schaltschrank nach Anspruch 1 oder 2,
dadurch gekennzeichnet,
daß die Außenseiten der Wandelemente (21 bis 24) und der Schranktüre (20) mit einer Lackierung als Oberflächenschutzbelag versehen sind.

5. HF-dichter Schaltschrank nach einem der Ansprüche 1 bis 4,
dadurch gekennzeichnet,
daß Öffnungen in den Wandelementen (24) des Schrankkorpus mittels aus Aluzink-Blech gefertigten Flanschplatten (25) verschließbar sind, die in bekannter Weise über Dichtungselemente (34) in Flanschplattenöffungen (26) der Wandelemente (24) einsetzbar sind, wobei die Flanschplatten (25) auf den den Innenseiten des Schrankkorpus zugekehrten Siten ohne Oberflächenschutzbelag versehen sind und die Dichtungselemente (34) tragen und
daß die Flanschplattenöffnungen (26) zumindest in den zugekehrten Anlageflächen ohne Oberflächenschutzbelag sind.

## Claims

1. HF-tight switchgear cabinet, including a cabinet body, which is comprisable or comprised of wall members and has at least one opening, which is closable by means of a cabinet door, and wherein gaps, formed in the cabinet body and between cabinet body and cabinet door, are sealed or sealable in an HF-tight manner by means of electrically and magnetically conductive sealing strips, characterised in that the wall members (21,22, 23,24, 24',24") and the cabinet door (20) are produced from aluzinc-coated sheet metal and are provided without any additional surface protective covering, at least in regions facing the gaps to be sealed, and in that the sealing strips (30,31, 32) are directly connected to the untreated surface of the wall members (21,22, 23, 24, 24',24") and/or cabinet door (20).

2. HF-tight switchgear cabinet according to claim 1, characterised in that it has a framework (10), which is produced from aluzinc sheet metal, without additional surface protective covering, on which framework the wall members (21 to 24), which are sealed by means of sealing strips, and the cabinet door (20) are mounted (Fig. 1).

3. HF-tight switchgear cabinet according to claim 1 or 2, characterised in that the external sides of the wall members (21 to 24) and of the cabinet door (20) are provided with a powder coating as the surface protective covering.

4. HF-tight switchgear cabinet according to claim 1 or 2, characterised in that the external sides of the wall members (21 to 24) and of the cabinet door (20) are provided with a painted finish as the surface protective covering.

5. HF-tight switchgear cabinet according to one of claims 1 to 4, characterised in that openings in the wall members (24) of the cabinet body are closable by means of flange plates (25), which are produced from aluzinc sheet metal and are insertable, in known manner, in flange plate openings (26) of the wall members (24) via sealing members (34), the flange plates (25) being provided on the sides facing the internal sides of the cabinet body without surface protective covering and carrying the sealing members (34), and in that the flange plate openings (26) are without surface protective covering, at least in the facing abutment faces.

## Revendications

1. Armoire de distribution étanche aux hautes fréquences avec un corps d'armoire pouvant être composé ou étant composé d'éléments d'habillage, armoire qui présente au moins une ouverture pouvant être fermée par une porte d'armoire et dans laquelle la fente formée sur l'armoire entre le corps de l'armoire et la porte d'armoire est fermée ou peut être fermée de manière étanche aux hautes fréquences au moyen de bandes d'étanchéité à conductivité électrique et magnétique,
caractérisée
en ce que les éléments d'habillage (21, 22, 23, 24, 24', 24") et la porte d'armoire (20) sont fabriqués en une tôle revêtue d'aluminium zingué et sont tout au moins dans les zones tournées vers les fentes à rendre étanches dépourvus de tout revêtement de protection supplémentaire, et
en ce que les bandes d'étanchéité (30, 31, 32) sont reliées directement à la surface non traitée des éléments d'habillage (21, 22, 23, 24, 24', 24") et/ou à la porte d'armoire (20).

2. Armoire de distribution étanche aux hautes fréquences suivant la revendication 1,
caractérisée
en ce qu'elle présente une ossature d'encadrement (10) fabriquée en une tôle revêtue d'aluminium zingué sans revêtement de protection de surface complémentaire, ossature sur laquelle sont fixées les éléments d'habillage (21 à 24) et la porte d'armoire (20) rendus étanches à l'aide de bandes d'étanchéité.

3. Armoire de distribution étanche aux hautes fréquences suivant la revendication 1 ou 2,
caractérisée
en ce que les faces extérieures des éléments d'habillage (21 à 24) et de la porte d'armoire (20) sont dotées d'un revêtement de poudre faisant office de revêtement de protection de surface.

4. Armoire de distribution étanche aux hautes fréquences suivant la revendication 1 ou 2,
caractérisée
en ce que les faces extérieures des éléments d'habillage (21 à 24) et de la porte d'armoire (20) sont dotées d'un revêtement de vernis ou de laque faisant office de revêtement de protection de surface.

5. Armoire de distribution étanche aux hautes fréquences suivant l'une quelconque des revendications de 1 à 4,
caractérisée
en ce que les ouvertures dans les éléments d'habillage (24) du corps de l'armoire peuvent être fermées au moyen de plaques à brides fabriquées en tôle revêtue d'aluminium zingué (25) qui de manière connue peuvent être placées par l'intermédiaire d'éléments d'étanchéité (34) dans les ouvertures bridées (26) des éléments d'habillage, les plaques à brides (25) étant sur les sites orientés vers les faces intérieures du corps de l'armoire dépourvues de revêtement de protection de surface et portant les éléments d'étanchéité, et
en ce que tout au moins sur les surfaces d'application, les ouvertures bridées (26) sont dépourvues de revêtement de protection de surface.
